# EUROPEAN PATENT APPLICATION

(11) **EP 4 550 412 A1**
(43) Date of publication of application: **07.05.2025**
(21) Application number: 24169960.2
(22) Date of filing: 12.04.2024
(51) Int. Cl.: H01L 23/473, H01L 23/427, H01L 23/04, H01L 23/10

(54) **COOLING MODULE FOR HETEROGENEOUS INTEGRATED SEMICONDUCTOR PACKAGE STRUCTURE**

(30) Priority: 31.10.2023 TW 112141879
(71) Applicant: Wistron Corporation, New Taipei City 22181 (TW)
(72) Inventor: TSAI, Chu-Chia, 22181 New Taipei City (TW); TANG, Tung-Yang, 22181 New Taipei City (TW); LIU, Wen-Hua, 22181 New Taipei City (TW); CHO, Chu-Shun, 22181 New Taipei City (TW)
(74) Representative: Viering, Jentschura & Partner mbB Patent- und Rechtsanwälte

(57) **Abstract**

A cooling module (2) for a heterogeneous integrated semiconductor package structure (I) is disclosed. The heterogeneous integrated semiconductor package structure (I) is arranged on a circuit board (B). The cooling module (2) includes a cooling plate (P) and a plurality of nanowires (nw). The nanowires (nw) may be configured to be bonded to the cooling plate (P), or may be configured to bond the cooling plate (P) to the heterogeneous integrated semiconductor package structure (I), or may be configured to bond the cooling plate (P) to the circuit board (B), or may be configured to bond the cooling plate (P) to both the heterogeneous integrated semiconductor package structure (I) and the circuit board (B).

## Description

### BACKGROUND

### Technical Field

The present disclosure relates to a cooling module, and in particular, to a cooling module configured to cool a semiconductor package structure.

### Related Art

With the advent of the era of high computational power in Artificial Intelligence (AI), the demand for High Performance Computing (HPC) and high-frequency, high-speed transmission is increasing. In response to this, a heterogeneous integrated package structure and a silicon photonics package structure have gradually become prominent.

However, semiconductor package structures with a higher computational power or higher-speed transmission all have a requirement for a heat dissipation design of a high power density or a high power dissipation. The existing air cooling technologies are increasingly struggling to cope with the growing heat dissipation requirements. In response to the situation, a future development trend of a cooling technology for servers or data centers gradually shifts from air cooling to liquid cooling. Current liquid cooling techniques involve the use of a liquid-cold plate in contact with the computing components, with a cooling liquid circulating through the interior of the liquid-cold plate to dissipate the heat generated by the computing components, thereby cooling them.

However, the most crucial aspect of the entire liquid cooling system is the sealing design. Any leakage in the liquid cooling system could potentially lead to electrical short circuits, and in severe cases, it might result in the system catching fire. Therefore, there is a pressing need in the industry for a sealing technology that is simple in its manufacturing process and provides excellent sealing performance.

### SUMMARY

In view of the above, embodiments of the present disclosure provide a cooling module for a heterogeneous integrated semiconductor package structure, which dissipates heat of a semiconductor package structure by using a cooling fluid. In addition to addressing the shortcomings of existing technologies, it further caters to the cooling demands associated with high-performance computing and high-speed transmission

An embodiment of the present disclosure provides a cooling module for a heterogeneous integrated semiconductor package structure. The heterogeneous integrated semiconductor package structure is arranged on a circuit board. The cooling module includes a cooling plate and a plurality of nanowires. The nanowires may be configured to bond the cooling plate to the heterogeneous integrated semiconductor package structure, bond the cooling plate to the circuit board, or bond the cooling plate to both the heterogeneous integrated semiconductor package structure and the circuit board.

In some embodiments, the cooling module may further include an intermediate foil, and the nanowires may be respectively arranged on two corresponding surfaces of the intermediate foil.

In some embodiments, the cooling plate may include a first surface, the heterogeneous integrated semiconductor package structure or the circuit board may include a second surface, and the nanowires may be arranged on at least one among the first surface or the second surface.

In some embodiments, the cooling module may further include a metal film or a metal frame, and the metal film or the metal frame may be arranged on the circuit board. In some embodiments, the cooling plate may be a vapor chamber that contacts the metal frame.

In some embodiments, the cooling module may further include a fluid supply module. A fluid channel is provided in the metal frame. The fluid channel may be in communication with the fluid supply module. The fluid supply module is adapted to supply a cooling fluid to the fluid channel.

In some embodiments, the heterogeneous integrated semiconductor package structure may include a first heat-generating portion and a second heat-generating portion. A thermal design power (TDP) of the first heat-generating portion is greater than a thermal design power of the second heat-generating portion. The cooling plate may include a plurality of fluid supply holes that respectively correspond to the first heat-generating portion and the second heat-generating portion. A flow rate of a cooling fluid sprayed onto the first heat-generating portion through the fluid supply holes is higher than the flow rate of the cooling fluid sprayed onto the second heat-generating portion through the fluid supply holes.

In some embodiments, the cooling plate may further include a main fluid chamber, a fluid supply chamber, a fluid recovery chamber, and a plurality of fluid recovery holes. The first heat-generating portion and the second heat-generating portion are located in the main fluid chamber. The fluid supply chamber is in communication with the main fluid chamber through the fluid supply holes. The fluid recovery chamber is in communication with the main fluid chamber through the fluid recovery holes. A configuration density of the fluid supply holes corresponding to the first heat-generating portion is greater than a configuration density of the fluid supply holes corresponding to the second heat-generating portion.

In some embodiments, the cooling module may further include a fluid storage unit, a fluid supply pipeline, a fluid recovery pipeline, a liquid supply pump, and a gas recovery pump. The fluid storage unit stores a cooling fluid. Two ends of each of the fluid supply pipeline and the fluid recovery pipeline may be respectively in communication with the fluid storage unit and the cooling plate. The liquid supply pump may be arranged on the fluid supply pipeline. The gas recovery pump may be arranged on the fluid recovery pipeline. The cooling fluid is supplied to the cooling plate through the liquid supply pump and the fluid supply pipeline, and the evaporated cooling fluid is drawn from the cooling plate through the gas recovery pump and the fluid recovery pipeline.

An embodiment of the present disclosure provides a cooling module for a heterogeneous integrated semiconductor package structure, including a cooling plate and a bonding interface. The bonding interface includes a plurality of nanowires. The cooling plate includes a first component and a second component. The first component and the second component are bonded to each other through the bonding interface. The bonding is performed at a temperature below 300°C.

In some embodiments, the bonding interface may further include a first surface and a second surface. The first surface may be located on the first component. The second surface may be located on the second component, and at least one among the first surface and the second surface comprises the nanowires

In some embodiments, the bonding interface may further include a first surface, a second surface, and an intermediate foil. The first surface may be located on the first component. The second surface may be located on the second component. The nanowires may be respectively arranged on two corresponding surfaces of the intermediate foil.

In some embodiments, the first component may be a hollow plate. The second component may be a fluid pipeline. The hollow plate may include an internal chamber and an opening. The fluid pipeline may be bonded to the opening through the bonding interface.

In some embodiments, the bonding interface may further include a first surface, a second surface, and an intermediate foil. The first surface may be located at the opening. The second surface may be located on an end of the fluid pipeline. The nanowires may be respectively arranged on two corresponding surfaces of the intermediate foil.

In some embodiments, the heterogeneous integrated semiconductor package structure may be arranged on an upper surface of a circuit board. The first component may be arranged on the heterogeneous integrated semiconductor package structure. The second component may be arranged on a lower surface of the circuit board. In some embodiments, the second component may include a plurality of protrusions. The protrusions may protrude toward the first component and be bonded to the first component along a side edge of the circuit board.

In some embodiments, the circuit board may include a plurality of through holes. The second component may include a plurality of protrusions. The protrusions may respectively extend through the through holes and be bonded to the first component. The first component includes an internal chamber and a plurality of openings. The second component may include a plurality of flow channels. The flow channels may respectively extend to the protrusions and be in communication with the internal chamber through the openings.

The summary presented above does not include an exhaustive list of all aspects of the instant disclosure. It is provided merely to introduce certain concepts and not to identify any key or essential features of the claimed subject matters.

### BRIEF DESCRIPTION OF THE DRAWINGS

FIG. 1A is a schematic cross-sectional view showing bonding of a cooling module to a heterogeneous integrated semiconductor package structure according to an embodiment of the instant disclosure.
FIG. 1B is a schematic cross-sectional view showing bonding of the cooling module to the heterogeneous integrated semiconductor package structure according to another embodiment of the instant disclosure.
FIG. 1C is a schematic cross-sectional view showing bonding of the cooling module to the heterogeneous integrated semiconductor package structure according to still another embodiment of the instant disclosure.
FIG. 1D is a schematic cross-sectional view showing bonding of the cooling module to the heterogeneous integrated semiconductor package structure according to yet another embodiment of the instant disclosure.
FIG. 2A is a schematic cross-sectional view showing bonding of the cooling module to a circuit board according to an embodiment of the instant disclosure.
FIG. 2B is a schematic cross-sectional view showing bonding of the cooling module to the circuit board according to another embodiment of the instant disclosure.
FIG. 2C is a schematic cross-sectional view showing bonding of the cooling module to the circuit board according to still another embodiment of the instant disclosure.
FIG. 2D is a schematic cross-sectional view showing bonding of the cooling module to the circuit board according to yet another embodiment of the instant disclosure.
FIG. 3A is a schematic cross-sectional view showing bonding of the cooling module to a metal frame according to an embodiment of the instant disclosure.
FIG. 3B is a schematic cross-sectional view showing bonding of the cooling module to the metal frame according to another embodiment of the instant disclosure.
FIG. 3C is a schematic cross-sectional view showing bonding of the cooling module to the metal frame according to still another embodiment of the instant disclosure.
FIG. 3D is a schematic cross-sectional view showing bonding of the cooling module to the metal frame according to yet another embodiment of the instant disclosure.
FIG. 4A is a schematic cross-sectional view showing bonding of the cooling module according to an embodiment of the instant disclosure.
FIG. 4B is a schematic cross-sectional view showing bonding of the cooling module according to another embodiment of the instant disclosure.
FIG. 4C is a schematic cross-sectional view showing bonding of the cooling module according to still another embodiment of the instant disclosure.
FIG. 4D is a schematic cross-sectional view showing bonding of the cooling module according to yet another embodiment of the instant disclosure.
FIG. 5A is a schematic cross-sectional view showing bonding of a pipeline of the cooling module according to an embodiment of the instant disclosure
FIG. 5B is a schematic cross-sectional view showing bonding of the pipeline of the cooling module according to another embodiment of the instant disclosure.
FIG. 5C is a schematic cross-sectional view showing bonding of the pipeline of the cooling module according to still another embodiment of the instant disclosure.
FIG. 5D is a schematic cross-sectional view showing bonding of the pipeline of the cooling module according to yet another embodiment of the instant disclosure.
FIG. 6 is a schematic cross-sectional view showing a specific application embodiment of the cooling module according to the instant disclosure.
FIG. 7 is a schematic cross-sectional view showing another specific application embodiment of the cooling module according to the instant disclosure.
FIG. 8A is a schematic diagram showing still another specific application embodiment of the cooling module according to the instant disclosure.
FIG. 8B is a schematic cross-sectional view showing the embodiment of FIG. 8A.
FIG. 9A is a schematic cross-sectional view showing another specific application embodiment of the cooling module according to the instant disclosure.
FIG. 9B is a schematic cross-sectional view showing still another specific application embodiment of the cooling module according to the instant disclosure.

### DETAILED DESCRIPTION

Various embodiments will now be described in detail below. It is important to note that these embodiments are provided as examples for illustration purposes and do not limit the scope of the disclosure. Additionally, certain components may be omitted from the diagrams in the embodiments to clearly illustrate the technical features of the instant disclosure. Furthermore, identical reference numerals will be used in all the figures to denote the same or similar elements, and the diagrams of the instant disclosure are intended for illustrative purposes and may not be drawn to scale. Not all details may be presented in the diagrams.

The following uses a heterogeneous integrated semiconductor packaging structure as an example of the object to be cooled. However, it is essential to note that the instant disclosure is not limited to this example, and other similar semiconductor packaging components, such as Silicon Photonics packaging components or other advanced packaging components, can also be applicable to the instant disclosure.

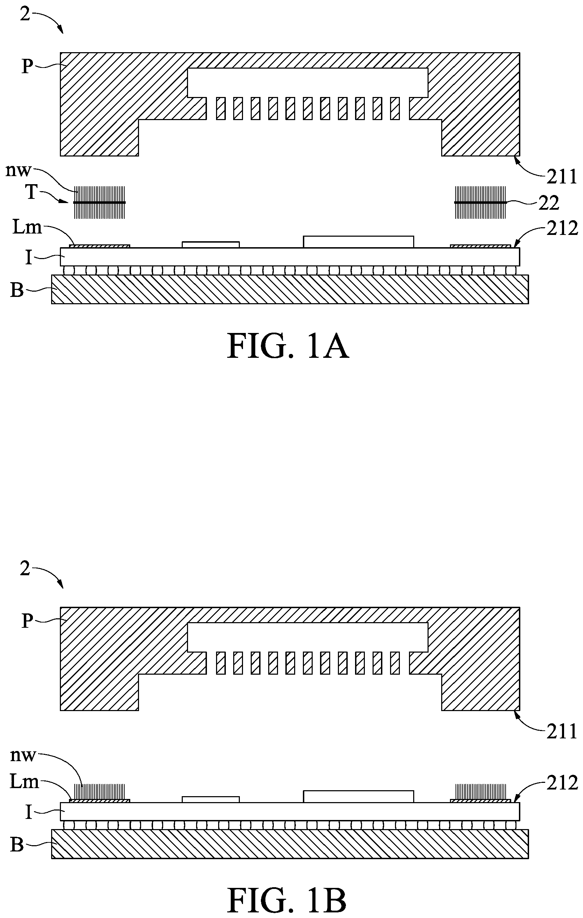

Referring to FIG. 1A, FIG. 1A is a schematic cross-sectional view showing bonding of a cooling module 2 to a heterogeneous integrated semiconductor package structure I according to an embodiment of the instant disclosure. In the figure, the heterogeneous integrated semiconductor package structure I is arranged on a circuit board B, and the cooling module 2 includes a cooling plate P and a nanowire tape T. The cooling plate P may be a liquid cold plate or a gas cold plate filled with a cooling fluid, or may be a vapor chamber, or may be other cooling plates with thermal conductivity or heat dissipation capabilities. It is important to note that the cooling fluid can be a refrigerant, pure water, ethylene glycol, propylene glycol, or their combinations. If considerations for non-conductive characteristics of the cooling fluid are required, deionized water, electronic fluorinated liquids, or other electronic engineering fluids can be used. However, the cooling fluid is not limited to liquids; it can also be a low-temperature gas, such as nitrogen, carbon dioxide, helium, or hydrogen, among other low-temperature gases.

The nanowire tape T includes an intermediate foil 22, which may be a metal foil or a polyimide (PI) film. The metal foil can be made of metals such as gold, silver, copper, or nickel. A thickness of the metal foil may be in a range of 5 µm to 2 mm. A thickness of the PI film may be less than 50 µm. A metal layer may be pre-applied on upper and lower surfaces of the film to facilitate formation of nanowires. A plurality of nanowires nw are arranged on the upper and lower surfaces of the intermediate foil 22, with diameters ranging from 30 nm to 4 µm and lengths ranging from 30 nm to 4 µm.

In some embodiments, the nanowires nw may be formed through an electroplating process. A formation method is briefly described as follows: First, two porous thin films are provided. In a specific example of the method for manufacturing porous films, a photoresist may be coated on a substrate, and then are exposed and developed to form the porous films. Next, a porous thin film is arranged on each of the upper and lower surfaces of the intermediate foil 22, and is added with electrodes and placed in an electrolyte for an electrochemical reaction, resulting in the growth of nanowires nw. Finally, the porous films may be removed through etching, completing the nanowire tape T.

In FIG. 1A, the nanowire tape T is arranged between the cooling plate P and the heterogeneous integrated semiconductor package structure I. Specifically, the cooling plate P has a first surface 211, the heterogeneous integrated semiconductor package structure I has a second surface 212. The desired bonding area on the second surface 212 of the heterogeneous integrated semiconductor packaging structure I may have a pre-formed metal film Lm, which can be made of metals such as gold, silver, copper, nickel, etc. The nanowires nw are respectively arranged on two corresponding surfaces of the intermediate foil 22. Before bonding, the nanowires nw are in a state of respectively extending toward the first surface 211 and the second surface 212 and substantially perpendicular to the two corresponding surfaces.

When the cooling plate P is to be bonded to the heterogeneous integrated semiconductor package structure I, the two components can be heated to approximately 170°C to 240°C.Applying a bonding pressure of about 10 MPa to 30 MPa for a duration of 120 seconds to 300 seconds will complete the bonding process. The nanowires nw, after bonding, bend and stack due to compression, resulting in a well-bonded structure with shear strength ranging from 20 MPa to 60 MPa, for instance. Furthermore, the bonded nanowires nw create a densely packed structure that serves as a sealed interface for fluids. Helium leak tests show leakage rates ranging from 9.5*10⁻⁹ mbar*1/s to 1.0*10⁻⁸ mbar*1/s, indicating a highly effective sealing capability.

FIG. 1B is a schematic cross-sectional view showing bonding of the cooling module 2 to the heterogeneous integrated semiconductor package structure I according to another embodiment of the instant disclosure. In the embodiment of FIG. 1B, the nanowires nw are directly formed on the second surface 212 of the heterogeneous integrated semiconductor package structure I. Before the bonding, the nanowires nw located on the second surface 212 extend toward the first surface 211 and substantially perpendicular to the second surface 212.

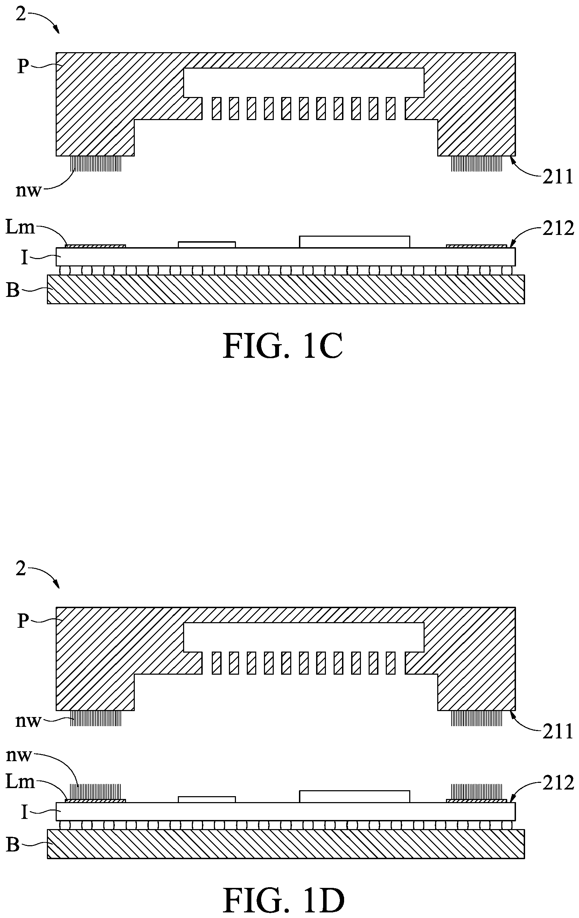

In this embodiment, for the method for forming the nanowires nw, refer to the above electroplating process. However, before the nanowires nw are formed, a metal film Lm needs to be first coated, which may be formed through a sputtering process, a chemical vapor deposition (CVD) process, and the electroplating process. For conditions and related parameters of the bonding between cooling plate P and the heterogeneous integrated semiconductor package structure I, refer to the above embodiments. In other embodiments, for example, an embodiment shown in FIG. 1C, the nanowires nw may be formed on the first surface 211 of the cooling plate P.

In addition, FIG. 1D is a schematic cross-sectional view showing bonding of the cooling module 2 to the heterogeneous integrated semiconductor package structure I according to yet another embodiment of the instant disclosure. In the embodiment shown in FIG. 1D, both the cooling plate P and the heterogeneous integrated semiconductor package structure I are equipped with the nanowires nw. That is to say, the nanowires nw are formed on both the first surface 211 and the second surface 212. After the bonding, the nanowires nw form an interdigitated structure, which is denser and higher in bonding strength.

To further elaborate, with this bonding method, it is even possible to conduct bonding at room temperature (approximately 20°C), with a bonding pressure of only 15 MPa, and the bonding process can be completed in 60 seconds. A shear strength after the bonding may reach a range of 6 MPa to 20 MPa. Certainly, to obtain a higher strength and more desirable sealing performance, the bonding temperature may be increased to a range of about 170°C to 240°C, and a bonding pressure in a range of about 15 MPa to 60 MPa may be provided for 120 seconds to 300 seconds. After the bonding is completed with the above parameters, the shear strength may reach a range of 20 Mpa to 65 MPa.

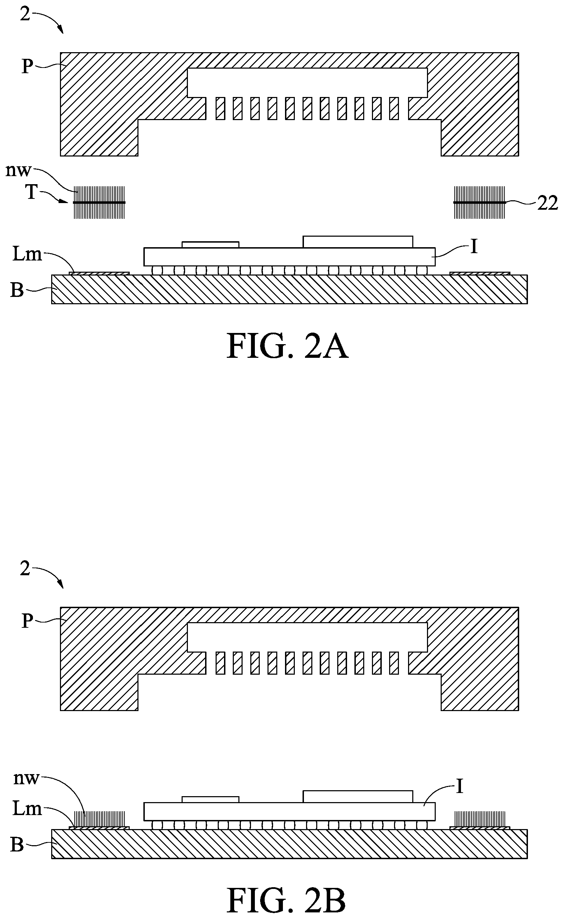

FIG. 2A is a schematic cross-sectional view showing bonding of the cooling module 2 to a circuit board B according to an embodiment of the instant disclosure. In the embodiment shown in FIG. 2A, the nanowire tape T is arranged between the cooling plate P and the circuit board B. The desired bonding area on the circuit board B may have a pre-formed metal film Lm. In this embodiment, the cooling plate P covers the entire heterogeneous integrated package structure I. When the cooling plate P is filled with a cooling fluid, the heterogeneous integrated package structure I may be immersed in the cooling fluid, resulting in a highly effective cooling effect.

It is particularly noted that, an advantage of using the nanowire tape T lies in the fact that there is no need to pre-form nanowires on the surfaces to be bonded on the cooling plate P, the heterogeneous integrated package structure I, or the circuit board B. Instead, only the nanowire tape T needs to be arranged at the desired bonding position, and then the cooling plate P and the circuit board B are heated and pressurized to complete the bonding, which simplifies the bonding process, thereby enhances efficiency.

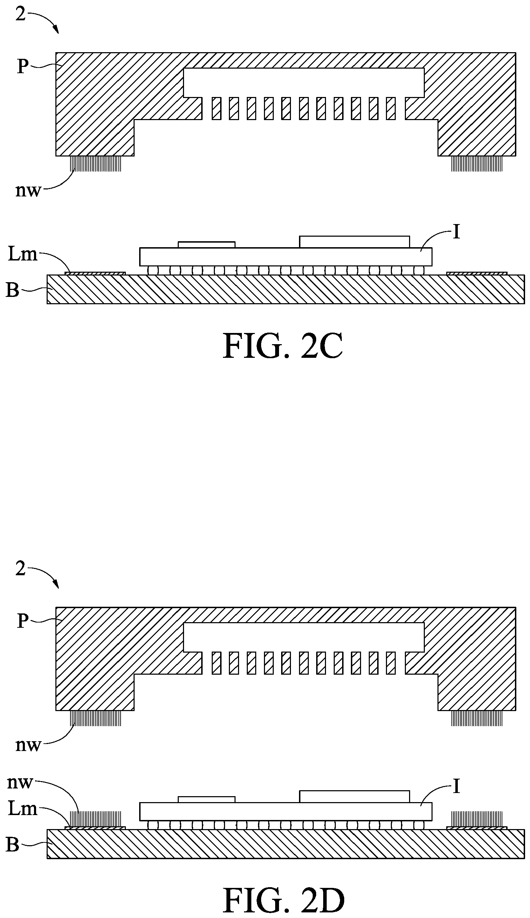

Similarly, in an embodiment shown in FIG. 2B, the nanowires nw may be formed on an upper surface of the circuit board B. Alternatively, in an embodiment shown in FIG. 2C, the nanowires nw may be formed on a lower surface of the cooling plate P. In addition, in an embodiment shown in FIG. 2D, the nanowires nw are formed not only on the upper surface of the circuit board B, but also on the lower surface of the cooling plate P.

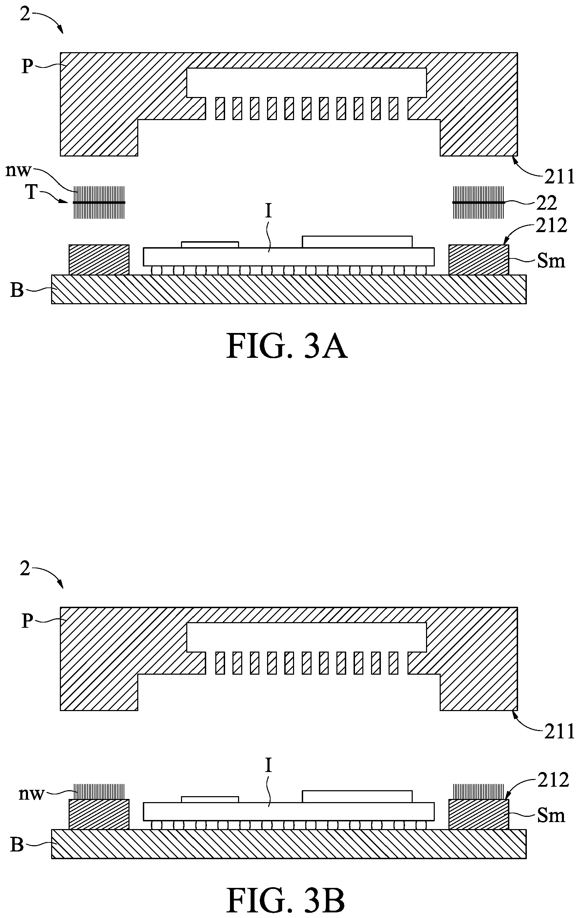

FIG. 3A is a schematic cross-sectional view showing bonding of the cooling module 2 to a metal frame Sm according to an embodiment of the instant disclosure. Amain difference between this embodiment and the previous embodiment lies in that the circuit board B features a metal frame Sm, which may be a commonly used stiffener or other metal components used to enhance the strength of the circuit board B. Therefore, the metal frame Sm may alternatively serve as a heat conduction member or a heat dissipation member, further enhancing the heat dissipation efficiency.

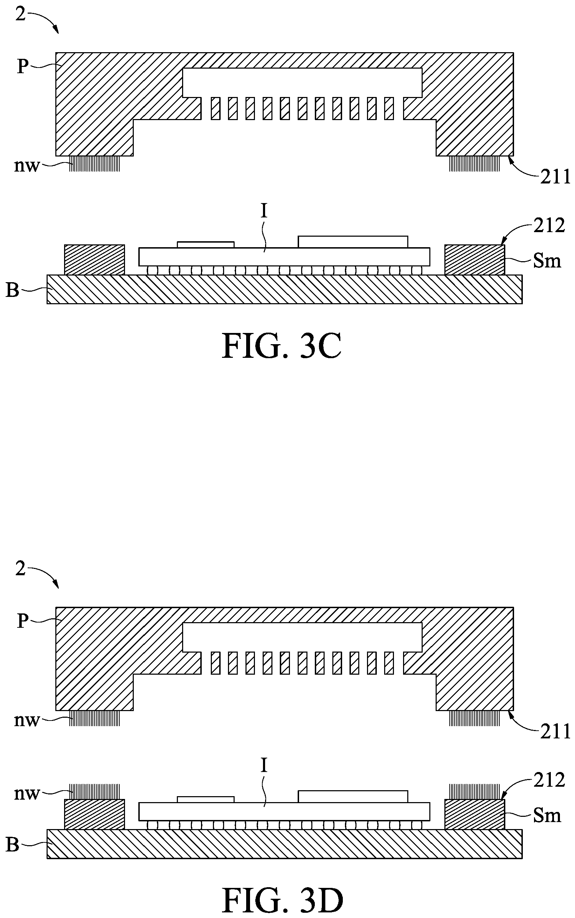

Similar to the previous embodiments, in FIG. 3A, the nanowire tape T is arranged between the cooling plate P and the metal frame Sm. In addition, in an embodiment shown in FIG. 3B, the nanowires nw may be formed on an upper surface of the metal frame Sm. Alternatively, in an embodiment shown in FIG. 3C, the nanowires nw may be formed on the lower surface of the cooling plate P. In addition, in an embodiment shown in FIG. 3D, the nanowires nw are formed not only on the upper surface of the metal frame Sm, but also on the lower surface of the cooling plate P.

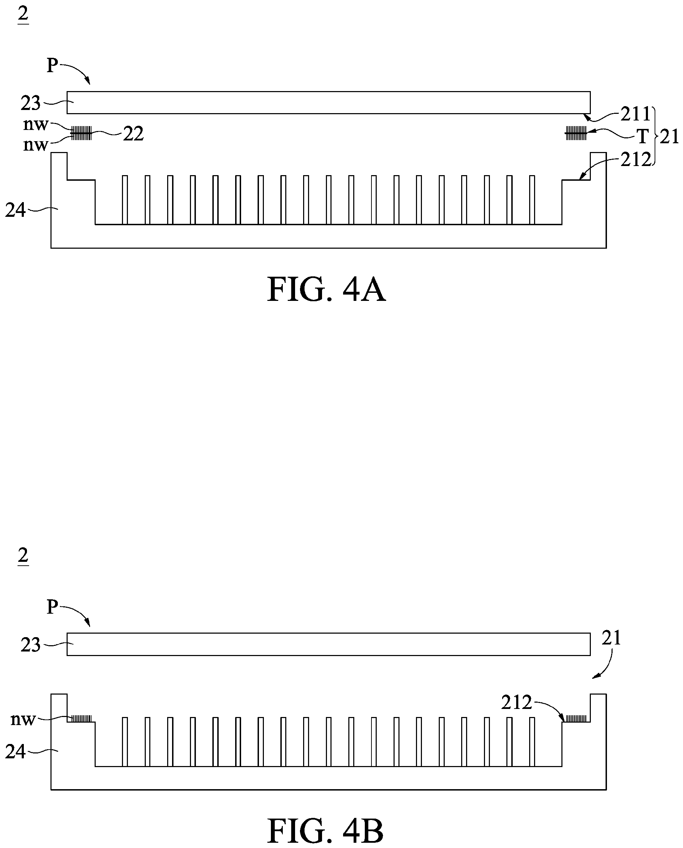

FIG. 4A is a schematic cross-sectional view showing bonding of the cooling module 2 according to an embodiment of the instant disclosure. In the embodiment shown in Figure 4A, a configuration for bonding the cooling plate P is provided. As shown in the figure, the cooling module 2 includes the cooling plate P and a bonding interface 21, and the bonding interface 21 includes a plurality of nanowires nw. The cooling plate P includes a first component 23 and a second component 24. The first component 23 is, for example, an upper lid, and the second component 24 is, for example, a base with a microchannel. The first component 23 and the second component 24 are bonded to each other through the bonding interface 21, and the bonding is performed at a temperature below 300°C. Further, the bonding at the temperature below 300°C is considered as a low-temperature process. Due to the bonding temperature not reaching the melting point of metals, the surfaces of microchannels or micro-pores inside the cooling plate P will not undergo deformation. Additionally, the mechanical properties of the cooling plate P will remain unchanged.

In this embodiment, the bonding interface 21 includes the first surface 211, the second surface 212, and the nanowire tape T. The first surface 211 is located on the first component 23, and the second surface 212 is located on the second component 24. The nanowire tape T includes the intermediate foil 22, and the nanowires nw are respectively arranged on the two corresponding surfaces of the intermediate foil 22. Before bonding, the nanowires nw respectively extend toward the first surface 211 and the second surface 212 and substantially perpendicular to the two corresponding surfaces.

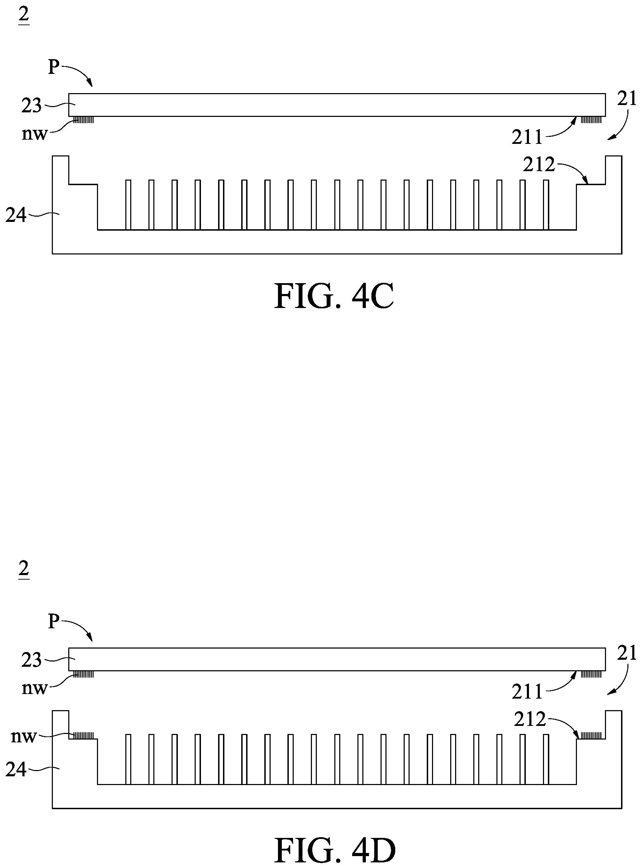

Similarly, in an embodiment shown in FIG. 4B, the nanowires nw may be formed on the second surface 212 of the second component 24. Alternatively, in an embodiment shown in FIG. 4C, the nanowires nw may be formed on the first surface 211 of the first component 23. In addition, in an embodiment shown in FIG. 4D, the nanowires nw are formed not only on the second surface 212 of the second component 24, but also on the first surface 211 of the first component 23.

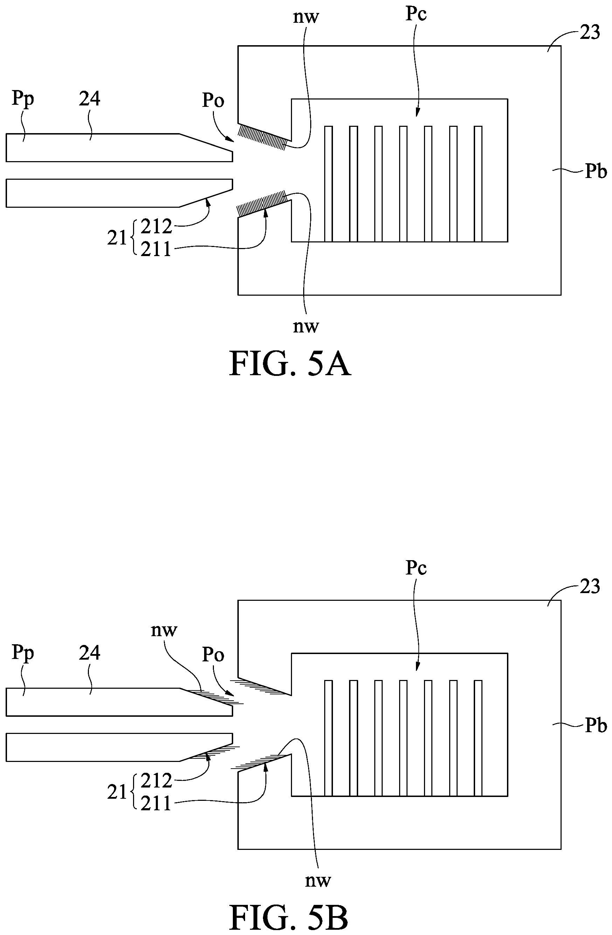

FIG. 5A is a schematic cross-sectional view showing bonding of a pipeline of the cooling module 2 according to an embodiment of the present disclosure, which specifically shows an implementation of bonding between a hollow plate Pb and a fluid pipeline Pp. Further, the hollow plate Pb may be a liquid cold plate with an internal chamber Pc and an opening Po, and the internal chamber Pc may include a plurality of microchannels. The bonding interface 21 between the hollow plate Pb and the fluid pipeline Pp includes the first surface 211, the second surface 212, and the nanowires nw. The first surface 211 is located at the opening Po, the second surface 212 is located at an end of the fluid pipeline Pp, and the nanowires nw are formed on the first surface 211.

In other embodiments, the nanowires nw may be formed on the second surface 212, or on both the first surface 211 and the second surface 212. Thus, by heating the hollow plate Pb and the fluid pipeline Pp to an appropriate temperature (below 300°C), inserting the fluid pipeline Pp into the opening Po of the hollow plate Pb, and applying the appropriate bonding pressure (10MPa to 30MPa) for 120 seconds to 300 seconds, the bonding between the two can be completed.

FIG. 5B is a schematic cross-sectional view showing bonding of the pipeline of the cooling module 2 according to another embodiment of the instant disclosure. A main difference between this embodiment and the above embodiment in FIG. 5A lies in that the nanowires nw are formed on both the first surface 211 and the second surface 212. Before bonding, the nanowires nw located on the first surface 211 extend toward the second surface 212, and the nanowires nw located on the second surface 212 extend toward the first surface 211. For example, in FIG. 5B, the nanowires nw located on the first surface 211 and the nanowires nw located on the second surface 212 both extend substantially in a horizontal direction. After bonding, the nanowires nw on the first surface 211 and the second surface 212 form an interdigitated structure, thereby achieving stronger bonding strength and superior sealing effectiveness.

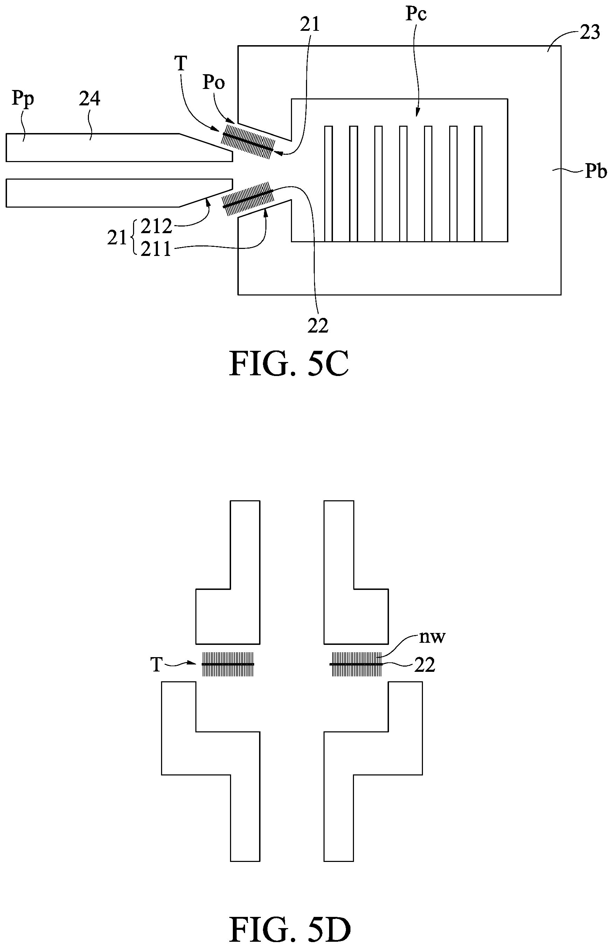

FIG. 5C is a schematic cross-sectional view showing bonding of the pipeline of the cooling module 2 according to still another embodiment of the instant disclosure. In the embodiment of FIG. 5C, the nanowire tape T is arranged between the first surface 211 at the opening Po and the second surface 212 on the end of the fluid pipeline Pp. It may be learned from the above that, in some embodiments, when the nanowire tape T needs to be used, the nanowire tape T only needs to be arranged at a desired bonding position, for example, arranged between the opening Po of the hollow plate Pb and the bonding end of the fluid pipeline Pp, and then heated and directly pressurized to complete the bonding. This is quite convenient.

FIG. 5D is a schematic cross-sectional view showing bonding of the pipeline of the cooling module 2 according to yet another embodiment of the instant disclosure. Similarly, the nanowire tape T may be further applied to bonding between pipelines, as long as bonding planes may be snugly attached to each other. For example, the nanowire tape may be applied to a flange structure used for pipeline bonding, but is not limited thereto. The nanowire tape T may be placed in the flange structure like a double-sided tape, which can achieve an excellent bonding strength and sealing effect.

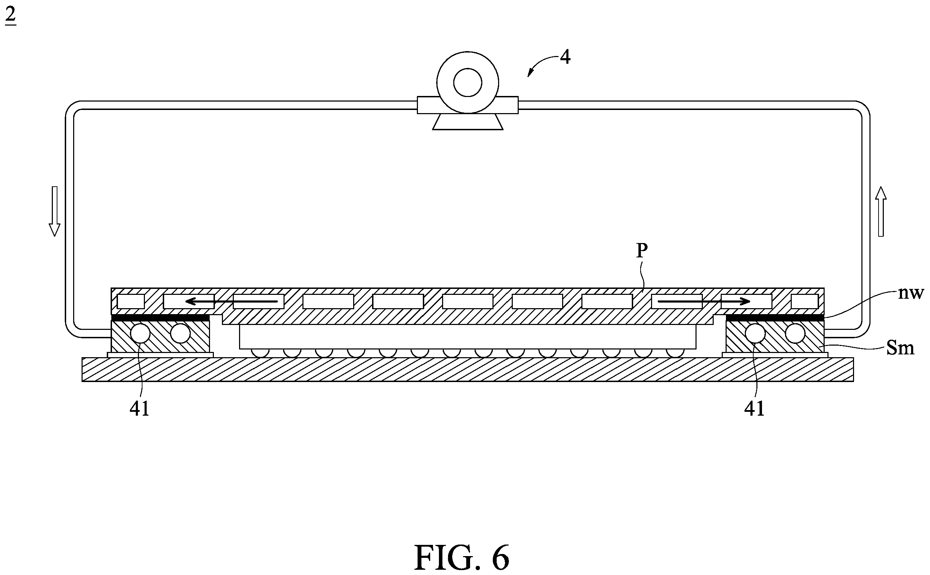

FIG. 6 is a schematic cross-sectional view showing a specific application embodiment of the cooling module 2 according to the instant disclosure. Further, some existing graphics processing units (GPUs) have omitted metal lids to reduce thermal resistance. However, to protect a processor and prevent the circuit board B from warping, the metal frame Sm, also referred to as a stiffener, is arranged around the processor instead. However, in the embodiment shown in FIG. 6, the metal frame Sm is fully utilized for heat conduction and dissipation.

In this embodiment, the cooling plate P is a vapor chamber that contacts the metal frame Sm, and the cooling plate P and the metal frame Sm are bonded to each other through the nanowires nw. In some embodiments, nanowires (nw) with excellent thermal conductivity, such as copper, may be used. With the characteristics of bonding using nanowires (nw), the cooling plate P and the metal frame Sm act as a single unit, achieving low thermal resistance and high bonding strength.

The vapor chamber has excellent heat conduction capabilities, allowing the semiconductor packaging structure with highly concentrated heat density to rapidly dissipate heat to the surroundings, preventing overheating of the semiconductor packaging structure. Furthermore, the figure shows a fluid supply module 4, which may include a pump and fluid delivery pipes. Fluid channels 41 are arranged in the metal frame Sm, which are in communication with the fluid supply module 4. The fluid supply module 4 is adapted to supply a cooling fluid to the fluid channel 41. Based on the above, in this embodiment, the metal frame Sm is fully utilized, and the cooling fluid channel is formed inside the metal frame Sm, to direct the heat toward the surrounding metal frame Sm. Taking advantage of the excellent heat conduction characteristics of the vapor chamber, the heat is directed to the metal frame Sm, dissipating heat quickly, and the cooling fluid takes it away, achieving rapid cooling and saving space.

In some embodiments, the fluid supply module 4 may further have a liquid storage tank (not shown in the figure) and a heat exchanger (not shown in the figure). The liquid storage tank may store a proper amount of cooling fluids, to ensure that the cooling fluid supply module 4 can continuously supply the cooling fluid to the metal frame Sm. The heat exchanger may be a finned heat exchanger with a fan, which further dissipates heat from the circulating cooling fluid. In other embodiments, the heat exchanger can also be a chiller, which further controls the temperature of the cooling fluid to a lower temperature.

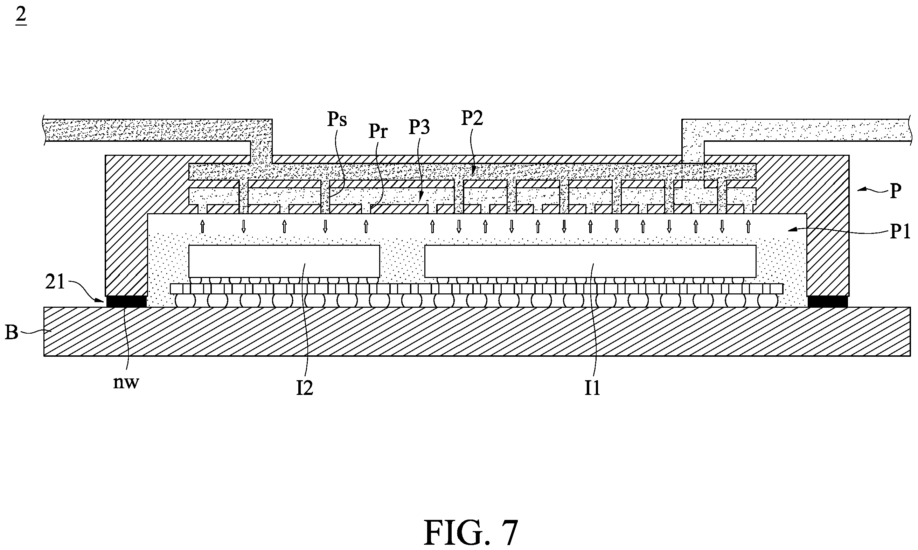

FIG. 7 is a schematic cross-sectional view showing another specific application embodiment of the cooling module 2 according to the instant disclosure. As shown in the figure, the heterogeneous integrated semiconductor package structure I includes a first heat-generating portion I1 and a second heat-generating portion I2. Each may be a chiplet. In this embodiment, a thermal design power (TDP) of the first heat-generating portion I1 is greater than a thermal design power of the second heat-generating portion I2. That is to say, during the operation of the two chiplets, a temperature of the first heat-generating portion I1 will be higher than a temperature of the second heat-generating portion I2. In this situation, an uneven temperature distribution of the entire packaging structure may occur, especially with the problem of thermal crosstalk, affecting the reliability of the semiconductor packaging structure.

As shown in FIG. 7, the cooling plate P may include a plurality of fluid supply holes Ps therein, which respectively correspond to the first heat-generating portion I1 and the second heat-generating portion I2. In some embodiments, to resolve the above problem of uneven temperatures in the semiconductor package structure, a jet impingement technology may be employed, which is implemented by for example causing a volume flow rate of a cooling fluid sprayed onto the first heat-generating portion I1 through the fluid supply holes Ps to be greater than a volume flow rate of the cooling fluid sprayed onto the second heat-generating portion I2 through the fluid supply holes Ps. The supply of the cooling fluid with a larger volume flow rate can carry more heat away compared with the supply of the cooling fluid with a smaller volume flow rate, thereby significantly lowing the temperature of the first heat-generating portion I1 and maintaining the temperatures of the first heat-generating portion I1 and the second heat-generating portion I2 as consistent as possible.

In a specific implementation, as shown in FIG. 7, the cooling plate P is bonded to the circuit board B through the nanowires nw. Due to the and the excellent sealing characteristics of the nanowires facilitate the formation of a sealed chamber between the cooling plate P and the circuit board B. The sealed chamber includes a main fluid chamber P1, a fluid supply chamber P2, a fluid recovery chamber P3, a plurality of fluid supply holes Ps, and a plurality of fluid recovery holes Pr. The first heat-generating portion I1 and the second heat-generating portion I2 are located in the main fluid chamber P1. The fluid supply holes Ps are configured to be in communication with the main fluid chamber P1 and the fluid supply chamber P2. The fluid recovery holes Pr are configured to be in communication with the main fluid chamber P1 and the fluid recovery chamber P3. A configuration density of the fluid supply holes Ps corresponding to the first heat-generating portion I1 is greater than a configuration density of the fluid supply holes Ps corresponding to the second heat-generating portion I2. The configuration density of the fluid supply holes Ps is related to the quantity, spacing, and arrangement of the holes.

In other words, compared with the second heat-generating portion I2, the first heat-generating portion I1 with a higher thermal design power (TDP) may be correspondingly configured with more and denser jet impingement-based spray holes (the fluid supply holes Ps), to enhance heat dissipation efficiency. Specific arrangement of the fluid supply holes Ps may be determined based on a heat flux (HF). A relational expression of the heat flux (HF) is as follows: Heat Flux (HF) = Thermal Design Power (TDP) / Surface Area of the heat-generating portion. For example, the heat flux (HF1) of the first heat-generating portion I1 is calculated as TDP1 (thermal design power of the first heat-generating portion I1) divided by the surface area of the first heat-generating portion I1; similarly, the heat flux (HF2) of the second heat-generating portion I2 is calculated as TDP2 (thermal design power of the second heat-generating portion I2) divided by the surface area of the second heat-generating portion I2. When the heat flux (HF1) of the first heat-generating portion I1 is greater than the heat flux (HF2) of the second heat-generating portion I2, the configuration density (ρ1) of the fluid supply holes Ps corresponding to the first heat-generating portion I1 should be greater than the configuration density (ρ2) of the fluid supply holes Ps corresponding to the second heat-generating portion I2.

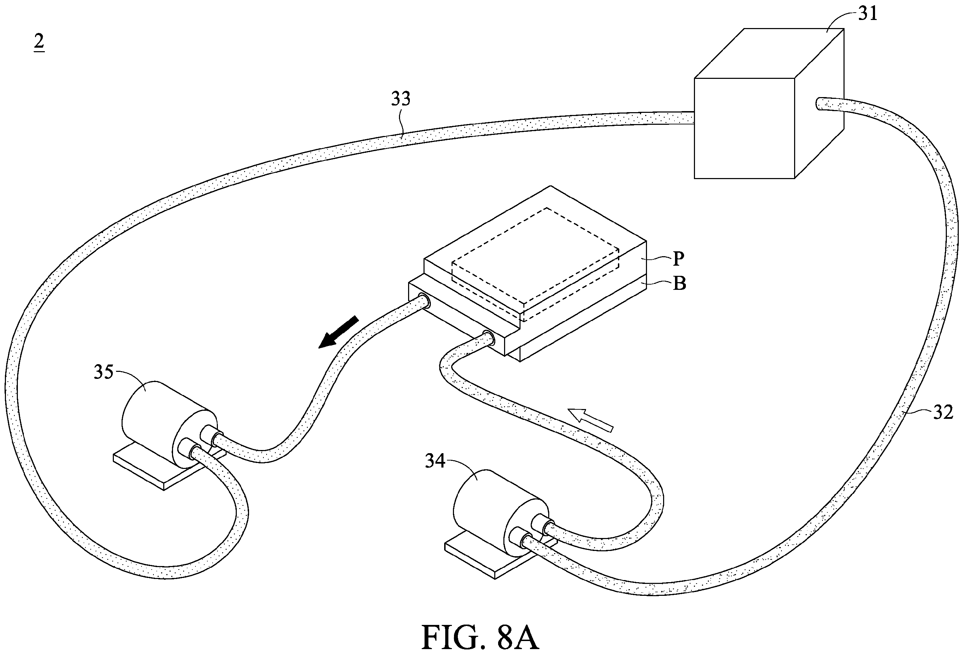

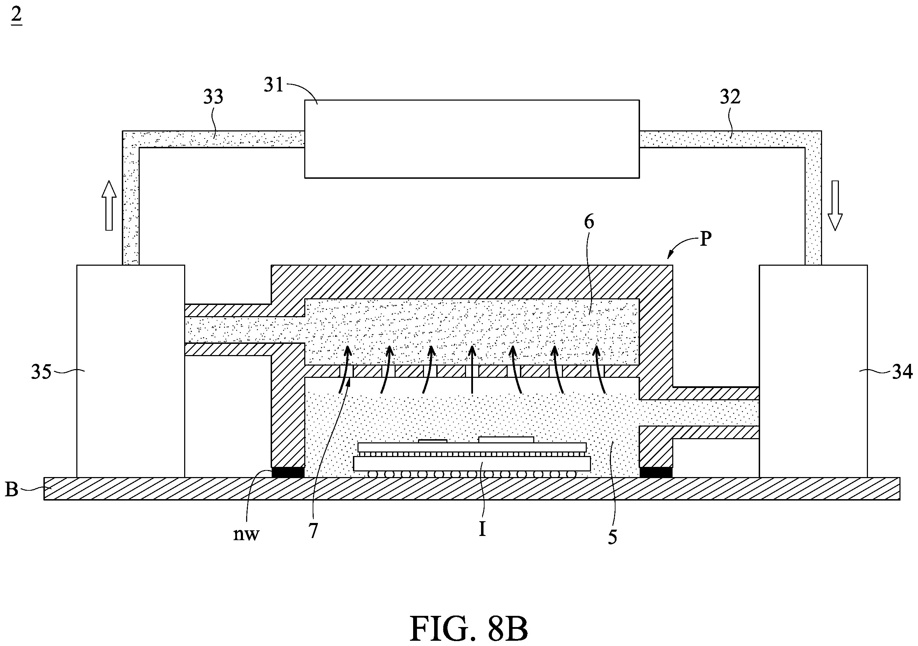

Referring to both FIG. 8A and FIG. 8B, FIG. 8A is a schematic diagram showing still another specific application embodiment of the cooling module 2 according to the present disclosure, and FIG. 8B is a schematic cross-sectional view of the embodiment of FIG. 8A. As shown in the figures, in this embodiment, the cooling module 2 includes a fluid storage unit 31, a fluid supply pipeline 32, a fluid recovery pipeline 33, a liquid supply pump 34, and a gas recovery pump 35. The fluid storage unit 31 stores a cooling fluid, and two ends of each of the fluid supply pipeline 32 and the fluid recovery pipeline 33 are respectively in communication with the fluid storage unit 31 and the cooling plate P.

In addition, the liquid supply pump 34 is arranged on the fluid supply pipeline 32, and the gas recovery pump 35 is arranged on the fluid recovery pipeline 33. The cooling fluid is supplied to the cooling plate P through the liquid supply pump 34 and the fluid supply pipeline 32, and the evaporated cooling fluid is drawn from the cooling plate P through the gas recovery pump 35 and the fluid recovery pipeline 33. In addition, as shown in FIG. 8B, the cooling plate P is bonded to the circuit board B through the nanowires nw. Due to the sealing characteristic of the nanowires nw during bonding, a sealed chamber may be formed by the cooling plate P and the circuit board B. The sealed chamber includes a liquid chamber 5 and a gas chamber 6, which are in communication with each other through a through hole 7.

Based on the above arrangement, in case of a high performance computing (HPC) requirement, the temperature of the heterogeneous integrated semiconductor package structure I may rise to a level sufficient to evaporate the cooling fluid, and thus result in coexistence of vapor and liquid-phase cooling fluid, for example, a two-phase immersion cooling scheme. In this case, the liquid-phase cooling fluid in the liquid chamber 5, after being heated and evaporated, will flow through the through hole 7 to the gas chamber 6. However, the gas recovery pump 35 in this embodiment can draw the gas from the gas chamber 6.

Overall, in this embodiment, through the liquid supply pump 34 and the fluid supply pipeline 32, the cooling fluid can be continuously supplied to the cooling plate P, and through the gas recovery pump 35 and the fluid recovery pipeline 33, the evaporated cooling fluid can be drawn from the cooling plate P. In this way, forced circulation of two-phase cooling fluids can be achieved, thereby maintaining excellent heat dissipation efficiency. In addition, in other embodiments, a heat exchanger (not shown in the figure) may be further arranged on the fluid recovery pipeline 33, which may be a finned heat exchanger with a fan, which further dissipates heat from the circulating gaseous cooling fluid, causing it to condense into a liquid cooling fluid.

Moreover, after the cooling module 2 has been in operation for an extended period, flow channels or holes in the cooling plate Ps may become narrower or even be completely blocked in severe cases as a result of various factors such as incomplete removal of debris after processing of the cooling plate P, precipitation of impurities in the cooling plate P, impurities in the cooling fluid, or growth of microorganisms in the microchannels or the cooling fluid. This will adversely affect the heat dissipation efficiency of the cooling plate Ps, resulting in overheating of system components, and in severe cases, equipment failure or damage.

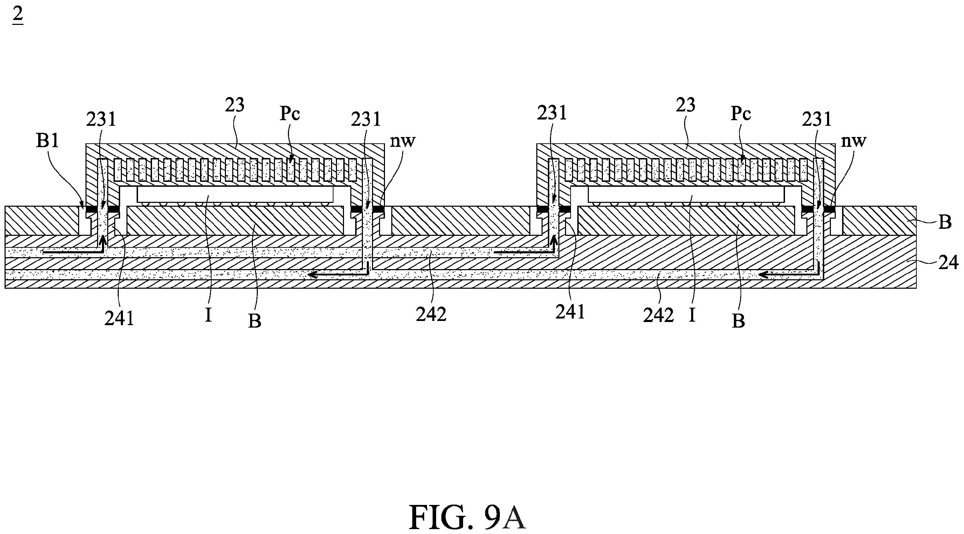

FIG. 9A is a schematic cross-sectional view showing another specific application embodiment of the cooling module 2 according to the instant disclosure. As shown in the figure, the heterogeneous integrated semiconductor package structure I is arranged on an upper surface of the circuit board B, the first component 23 is arranged on the heterogeneous integrated semiconductor package structure I, and the second component 24 is arranged on a lower surface of the circuit board B. In some embodiments, the first component 23 may be a cooling plate P, and the second component 24 may be a guide back plate.

Furthermore, the circuit board B includes a plurality of through holes B1, and the second component 24 includes a plurality of protrusions 241. The protrusions 241 respectively extend through the through holes B1 and are bonded to the first component 23. The bonding interface 21 between the protrusions 241 of the second component 24 and the first component 23 includes the nanowires nw. In addition, the first component 23 includes an internal chamber Pc and a plurality of openings 231, and the second component 24 includes a plurality of flow channels 242. The flow channels 242 respectively extend to the protrusions 241 and are in communication with the internal chamber Pc through the openings 231.

Therefore, through the excellent bonding strength and sealing characteristic of the nanowires nw, not only can the first component 23 and the second component 24 be securely bonded, but the risk of fluid leakage at the bonding can also be significantly reduced. In addition, in this embodiment, placing the flow path beneath the circuit board B can greatly save space, and connection of the fluid flow paths may be completed during assembly of the cooling plate P, facilitating fully automated assembly. Moreover, during bonding through the nanowires nw, the bonding may be completed merely by slight heating and pressing of first component 23 and the second component 24, eliminating the need for additional water channels. This greatly reduces the use of connectors, making assembly quick and easy.

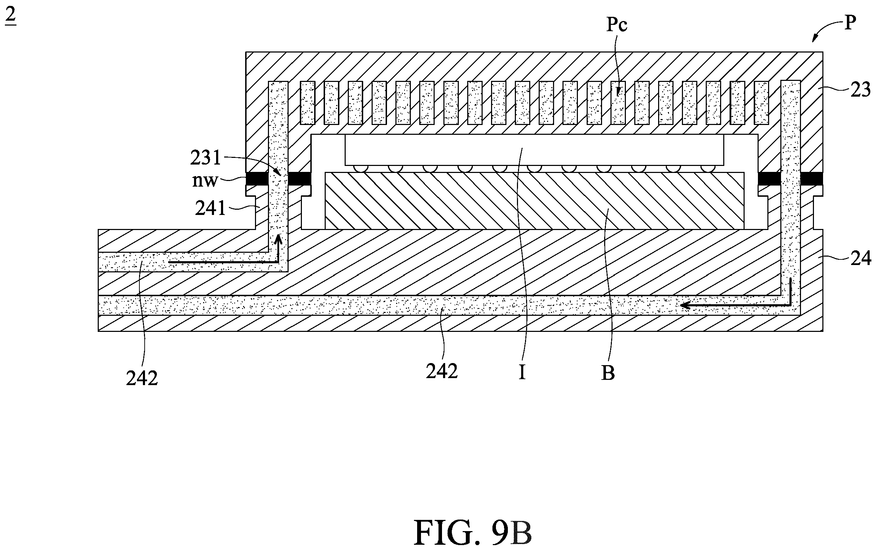

FIG. 9B is a schematic cross-sectional view showing still another specific application embodiment of the cooling module 2 according to the instant disclosure. A main difference between this embodiment and the above embodiment lies in that the bonding position between the first component 23 and the second component 24 is at a side edge of the circuit board B. Further, as shown in FIG. 9B, the first component 23 includes an internal chamber Pc and a plurality of openings 231, and the second component 24 includes a plurality of protrusions 241 and a plurality of flow channels 242. The protrusions 241 protrude toward the first component 23, and the flow channels 242 respectively extend to the protrusions 241. The protrusions 241 are bonded to the first component 23 along the side edge of the circuit board B, and the flow channels 242 of the second component 24 are in communication with the internal chamber Pc through the openings 231.

## Claims

1. A cooling module (2) for a heterogeneous integrated semiconductor package structure (I), wherein the heterogeneous integrated semiconductor package structure (I) is arranged on a circuit board (B), the cooling module (2) comprises a cooling plate (P) and a plurality of nanowires (nw), and the nanowires (nw) are configured to bond the cooling plate (P) to the heterogeneous integrated semiconductor package structure (I), bond the cooling plate (P) to the circuit board (B), or bond the cooling plate (P) to both the heterogeneous integrated semiconductor package structure (I) and the circuit board (B).

2. The cooling module (2) according to claim 1, further comprising an intermediate foil (22), wherein the nanowires (nw) are respectively arranged on two corresponding surfaces of the intermediate foil (22).

3. The cooling module (2) according to claim 1, wherein the cooling plate (P) comprises a first surface (211), the heterogeneous integrated semiconductor package structure (I) or the circuit board (B) comprises a second surface (212), and the nanowires (nw) are arranged on at least one among the first surface (211) and the second surface (212).

4. The cooling module (2) according to any of claims 1-3, further comprising a metal film (LM) or a metal frame (Sm), wherein the metal film (LM) or the metal frame (Sm) is arranged on the circuit board (B), and the cooling plate (P) is a vapor chamber that contacts the metal film (LM) or the metal frame (Sm).

5. The cooling module (2) according to claim 4, further comprising a fluid supply module (4), wherein a fluid channel (41) is provided in the metal frame (Sm), the fluid channel (41) is in communication with the fluid supply module (4), and the fluid supply module (4) is adapted to supply a cooling fluid to the fluid channel (41).

6. The cooling module (2) according to any of claims 1-5, wherein the heterogeneous integrated semiconductor package structure (I) comprises a first heat-generating portion (I1) and a second heat-generating portion (I2), a thermal design power of the first heat-generating portion (I1) is greater than a thermal design power of the second heat-generating portion (I2), the cooling plate (P) comprises a plurality of fluid supply holes (Ps) that respectively correspond to the first heat-generating portion (I1) and the second heat-generating portion (I2); wherein a flow rate of a cooling fluid sprayed onto the first heat-generating portion (I1) through the fluid supply holes (Ps) is greater than the flow rate of the cooling fluid sprayed onto the second heat-generating portion (I2) through the fluid supply holes (Ps).

7. The cooling module (2) according to claim 6, wherein the cooling plate (P) further comprises a main fluid chamber (P1), a fluid supply chamber (P2), a fluid recovery chamber (P3), and a plurality of fluid recovery holes (Pr), the first heat-generating portion (I1) and the second heat-generating portion (I2) are located in the main fluid chamber (P1), the fluid supply chamber (P2) is in communication with the main fluid chamber (P1) through the fluid supply holes (Ps), the fluid recovery chamber (P3) is in communication with the main fluid chamber (P1) through the fluid recovery holes (Pr); wherein a configuration density of the fluid supply holes (Ps) corresponding to the first heat-generating portion (I1) is greater than a configuration density of the fluid supply holes (Ps) corresponding to the second heat-generating portion (I2).

8. The cooling module (2) according to any of claims 1-5, further comprising a fluid storage unit (31), a fluid supply pipeline (32), a fluid recovery pipeline (33), a liquid supply pump (34), and a gas recovery pump (35), wherein the fluid storage unit (31) stores a cooling fluid, two ends of each of the fluid supply pipeline (32) and the fluid recovery pipeline (33) are respectively in communication with the fluid storage unit (31) and the cooling plate (P), the liquid supply pump (34) is arranged on the fluid supply pipeline (32), the gas recovery pump (35) is arranged on the fluid recovery pipeline (33), the cooling fluid is supplied to the cooling plate (P) through the liquid supply pump (34) and the fluid supply pipeline (32), and the evaporated cooling fluid is drawn from the cooling plate (P) through the gas recovery pump (35) and the fluid recovery pipeline (33).

9. A cooling module (2) for a heterogeneous integrated semiconductor package structure (I), comprising:
a cooling plate (P); and
a bonding interface (21), comprising a plurality of nanowires (nw), wherein
the cooling plate (P) comprises a first component (23) and a second component (24), the first component (23) and the second component (24) are bonded to each other through the bonding interface (21), and the bonding is performed at a temperature below 300°C.

10. The cooling module (2) according to claim 9, wherein the bonding interface (21) further comprises a first surface (211) and a second surface (212), the first surface (211) is located on the first component (23), the second surface (212) is located on the second component (24), and at least one among the first surface (211) and the second surface (212) comprises the nanowires (nw).

11. The cooling module (2) according to claim 9, wherein the bonding interface (21) further comprises a first surface (211), a second surface (212), and an intermediate foil (22), the first surface (211) is located on the first component (23), the second surface (212) is located on the second component (24), and the nanowires (nw) are respectively arranged on two corresponding surfaces of the intermediate foil (22).

12. The cooling module (2) according to claim 9, wherein the first component (23) is a hollow plate (Pb), the second component (24) is a fluid pipeline (Pp), the hollow plate (Pb) comprises an internal chamber (Pc) and an opening (Po), and the fluid pipeline (Pp) is bonded to the opening (Po) through the bonding interface (21).

13. The cooling module (2) according to claim 12, wherein the bonding interface (21) further comprises a first surface (211), a second surface (212), and an intermediate foil (22), the first surface (211) is located at the opening (Po), the second surface (212) is located on an end of the fluid pipeline (Pp), and the nanowires (nw) are respectively arranged on two corresponding surfaces of the intermediate foil (22).

14. The cooling module (2) according to any of claims 9-13, wherein the heterogeneous integrated semiconductor package structure (I) is arranged on an upper surface of a circuit board (B), the first component (23) is arranged on the heterogeneous integrated semiconductor package structure (I), and the second component (24) is arranged on a lower surface of the circuit board (B); wherein the second component (24) comprises a plurality of protrusions (241), and the protrusions (241) protrude toward the first component (23) and are bonded to the first component (23) along a side edge of the circuit board (B).

15. The cooling module (2) according to any of claims 9-13, wherein the heterogeneous integrated semiconductor package structure (I) is arranged on an upper surface of a circuit board (B), the first component (23) is arranged on the heterogeneous integrated semiconductor package structure (I), and the second component (24) is arranged on a lower surface of the circuit board (B); the second component (24) comprises a plurality of protrusions (241), the circuit board (B) comprises a plurality of through holes (B1), the protrusions (241) of the second component (24) respectively extend through the through holes (B 1) and are bonded to the first component (23), the first component (23) comprises an internal chamber (Pc) and a plurality of openings (Po), the second component (24) comprises a plurality of flow channels (242), and the flow channels (242) respectively extend to the protrusions (241) and are in communication with the internal chamber (Pc) through the openings (Po).

## Amended claims

### Amended claims in accordance with Rule 137(2) EPC.

1. A cooling module (2) for a heterogeneous integrated semiconductor package structure (I), wherein the heterogeneous integrated semiconductor package structure (I) is arranged on a circuit board (B), the cooling module (2) comprises a cooling plate (P) and a plurality of nanowires (nw), and the nanowires (nw) are configured to bond the cooling plate (P) to the heterogeneous integrated semiconductor package structure (I), bond the cooling plate (P) to the circuit board (B), or bond the cooling plate (P) to both the heterogeneous integrated semiconductor package structure (I) and the circuit board (B);
wherein the heterogeneous integrated semiconductor package structure (I) comprises a first heat-generating portion (I1) and a second heat-generating portion (I2), a thermal design power of the first heat-generating portion (I1) is greater than a thermal design power of the second heat-generating portion (I2), the cooling plate (P) comprises a plurality of fluid supply holes (Ps) that respectively correspond to the first heat-generating portion (I1) and the second heat-generating portion (I2); wherein a flow rate of a cooling fluid sprayed onto the first heat-generating portion (I1) through the fluid supply holes (Ps) is greater than the flow rate of the cooling fluid sprayed onto the second heat-generating portion (I2) through the fluid supply holes (Ps); the fluid supply holes (Ps) comprises a plurality of jet impingement-based spray holes.

2. The cooling module (2) according to claim 1, further comprising an intermediate foil (22), wherein the nanowires (nw) are respectively arranged on two corresponding surfaces of the intermediate foil (22).

3. The cooling module (2) according to claim 1, wherein the cooling plate (P) comprises a first surface (211), the circuit board (B) comprises a second surface (212), and the nanowires (nw) are arranged on at least one among the first surface (211) and the second surface (212).

4. The cooling module (2) according to any of claims 1-3, wherein the first heat-generating portion (I1) and the second heat-generating portion (I2) are respectively a chiplet.

5. The cooling module (2) according to any of claims 1-4, wherein the cooling plate (P) further comprises a main fluid chamber (P1), a fluid supply chamber (P2), a fluid recovery chamber (P3), and a plurality of fluid recovery holes (Pr), the first heat-generating portion (I1) and the second heat-generating portion (I2) are located in the main fluid chamber (P1), the fluid supply chamber (P2) is in communication with the main fluid chamber (P1) through the fluid supply holes (Ps), the fluid recovery chamber (P3) is in communication with the main fluid chamber (P1) through the fluid recovery holes (Pr).

6. The cooling module (2) according to any of claims 1-5, wherein a configuration density of the fluid supply holes (Ps) corresponding to the first heat-generating portion (I1) is greater than a configuration density of the fluid supply holes (Ps) corresponding to the second heat-generating portion (I2).

7. The cooling module (2) according to any of claims 1-6, wherein a number of the fluid supply holes (Ps) corresponding to the first heat-generating portion (I1) is greater than a number of the fluid supply holes (Ps) corresponding to the second heat-generating portion (I2).

8. The cooling module (2) according to any of claims 1-7, wherein a heat flux of the first heat-generating portion (I1) is greater than a heat flux of the second heat-generating portion (I2); the heat flux of the first heat-generating portion (I1) is calculated as the thermal design power of the first heat-generating portion (I1) divided by a surface area of the first heat-generating portion (I1), the heat flux of the second heat-generating portion (I2) is calculated as the thermal design power of the second heat-generating portion (I2) divided by a surface area of the second heat-generating portion (I1).
